# EUROPÄISCHE PATENTSCHRIFT

(11) **EP 4 351 159 B1**
(45) Veröffentlichungstag und Bekanntmachung des Hinweises auf die Patenterteilung: **20.08.2025**
(21) Anmeldenummer: 23201768.1
(22) Anmeldetag: 05.10.2023
(51) Int. Cl.: H04N 25/13, H04N 25/704, H10F 39/18, H10F 39/00

(54) **BILDSENSOR**
IMAGE SENSOR
CAPTEUR D'IMAGE

(30) Priorität: 06.10.2022 DE 102022125838
(43) Veröffentlichungstag der Anmeldung: 10.04.2024
(73) Patentinhaber: Arnold & Richter Cine Technik GmbH & Co. Betriebs KG, 80807 München (DE)
(72) Erfinder: Cieslinski, Michael, 81927 München (DE)
(74) Vertreter: Manitz Finsterwald Patent- und Rechtsanwaltspartnerschaft mbB

(56) Entgegenhaltungen:
- EP-A1- 2 738 812
- EP-A1- 3 236 500
- US-A1- 2016 181 298

## Beschreibung

Die Erfindung betrifft einen Bildsensor, insbesondere einen CMOS-Bildsensor, für eine elektronische Kamera, der eine Vielzahl von in Zeilen und Spalten angeordneten Pixeln aufweist, von denen jedes einem von zumindest drei Farbkanälen zugeordnet ist, wobei jedes Pixel zumindest ein lichtempfindliches Detektorelement, das dazu ausgebildet ist, in Abhängigkeit von auftretendem Licht elektrische Signale zu erzeugen, sowie einen Farbfilter umfasst, welcher das Licht vor dem Auftreffen auf das zumindest eine Detektorelement gemäß dem Farbkanal, dem das jeweilige Pixel zugeordnet ist, filtert. Ein Bildsensor nach dem Oberbegriff des Anspruchs 1 wird beispielsweise in EP 3 236 500 A1 beschrieben. Ein Bildsensor mit diagonal geteilten Pixeln ist aus EP 2 738 812 A1 bekannt. US 2016/181298 A1 beschreibt einen Bildsensor, bei dem Ausleseelektronik in Zwischenräumen angeordnet ist, an die jeweils vier Pixel angrenzen.

Elektronische Kameras können in der Regel sowohl als Stillbildkamera als auch als Bewegtbildkamera genutzt werden. Als Bewegtbildkamera kann eine elektrische Kamera insbesondere dazu verwendet werden, Bildsequenzen aufzunehmen. Wenn aufgenommene derartige Bildsequenzen mit hoher Auflösung auf einer großen Fläche, beispielsweise auf der Leinwand eines Kinos, wiedergegeben werden sollen, ist es wichtig, dass die jeweilige Kamera eine hohe Bildqualität aufweist. Denn insbesondere bei Kinoproduktionen ist der Anspruch in der Regel sehr hoch, und bei der Projektion auf eine große Leinwand sind Bildfehler leicht erkennbar.

Elektronische Kameras enthalten einen Bildsensor, der durch ein Objektiv der Kamera in die Kamera eindringendes und letztlich auf den Bildsensor auftreffendes Licht in elektrische Signale umwandelt. Der Bildsensor umfasst eine Vielzahl von Pixeln, die jeweils ein lichtempfindliches Detektorelement umfassen, welches entsprechend der Intensität des auf das jeweilige Pixel auftreffenden Lichts elektrische Ladung erzeugen. Dadurch, dass jedes Pixel einen Farbfilter umfasst, trifft auf das zumindest eine Detektorelement des jeweiligen Pixels nur derjenige Anteil des Lichts, den der jeweilige Farbfilter durchlässt und der somit eine dem Farbfilter entsprechende Farbe aufweist. Infolgedessen ist jedes Pixel einem der Farbe (Spektralbereich) seines jeweiligen Farbfilters entsprechenden Farbkanal zugeordnet. Für das Auslesen des Bildes (d. h. eines Einzelbildes der Bildsequenz) werden die Pixel über eine Ausleseelektronik der Reihe nach adressiert und es wird eine zur jeweiligen Ladung der Pixel proportionale Spannung zu einem Signalausgang des Bildsensors geleitet.

Für die Qualität einer Bildaufnahme ist es wichtig, dass das aufgenommene Motiv scharf abgebildet wird. Dazu muss der Fokus der Kamera korrekt eingestellt sein, d. h. die Schärfenebene des Objektivs der Kamera muss so eingestellt sein, dass das Motiv in der Schärfenebene liegt. Beispielsweise soll im Falle eines Portrait-Bildes die Schärfenebene in der Regel auf das der Kamera zugewandte Auge eingestellt sein.

Wenn das Objektiv der Kamera motorisiert verstellbar ist, besteht die Möglichkeit einer automatisierten Fokussierung (sogenannter Autofokus). Hierzu muss die Kamera ein Steuersignal für den Objektivantrieb generieren, um die Schärfenebene auf die richtige Position zu verfahren. Zur Bestimmung des Steuersignals sind verschiedene Autofokus-Verfahren bekannt.

Ein Teil dieser Verfahren nutzt externe Sensoren, die beispielsweise auf Ultraschallmessung oder Stereoskopie beruhen können, um die optimale Fokuseinstellung zu bestimmen. Da bei diesen Verfahren das jeweilige Motiv aus dem Blickwinkel des jeweiligen externen Sensors und somit aus einem anderen Blickwinkel als demjenigen der Kamera erfasst wird, ergibt sich stets eine Parallaxe, die zu Fehlern bei der Fokussierung führen kann. Dadurch ist die Anwendung solcher Verfahren für Aufnahmen mit hohem Qualitätsanspruch limitiert.

Solche Parallaxen-Fehler lassen sich durch Verfahren vermeiden, bei denen das jeweilige Motiv für die Ermittlung der Fokuseinstellung durch das Objektiv der Kamera erfasst wird. Daher sind derartige "interne" Autofokus-Verfahren grundsätzlich weniger limitiert und genauer als Verfahren, die externe Sensoren nutzen.

Verfahren, bei denen die Fokuseinstellung durch das Objektiv der Kamera hindurch ermittelt wird, lassen sich in zwei Klassen einteilen: einerseits Verfahren, die einen vom für die eigentliche Aufnahme verwendeten Bildsensor der Kamera unabhängigen zusätzlichen Sensor verwenden, und andererseits Verfahren, die den Bildsensor selbst zur Ermittlung der korrekten Fokuseinstellung nutzen.

Bei Verfahren mit einem zusätzlichen Sensor ist es erforderlich, einen Teil des durch das Objektiv in die Kamera eindringenden Lichts in Richtung zu dem zusätzlichen Sensor auszuspiegeln. Der dazu benötigte Spiegel erfordert zusätzlichen Bauraum, der die Kamera vergrößert und bei modernen Objektiven nicht zur Verfügung steht. Außerdem geht durch das Ausspiegeln ein Teils des Lichts für die Bildaufnahme verloren.

Daher sind Verfahren vorteilhaft, bei denen der für die Aufnahme verwendete Bildsensor auch zur Ermittlung der korrekten Fokuseinstellung genutzt wird. Für solche Verfahren sind zwei grundlegende Prinzipien bekannt: zum einen der Kontrast-Autofokus und zum anderen der Autofokus mittels PDAF-Pixeln, wobei PDAF für "Phase Detection Auto Focus" steht.

Beim Kontrast-Autofokus wird die Schärfenebene zunächst durchfahren und die Position mit der maximalen Schärfe bestimmt, wobei die Schärfe anhand des Kontrasts des bei der jeweiligen Position aufgenommenen Bildes ermittelt wird. An dieser Position lässt man die Schärfenebene mit geringer Amplitude oszillieren, um die optimale Lage zu finden und anschließend zu verfolgen, d. h. fortlaufend nachzujustieren. Während dieses Verfahren bei Stillbildaufnahmen sehr gut funktioniert, ist bei Bewegtbildaufnahmen jedoch die im Bewegtbild wahrnehmbar oszillierende Schärfenebene störend. Der Grund für die Oszillation liegt darin, dass bei einem solchen Verfahren keine direkte Information über den Grad der Defokussierung gewonnen wird und auch nicht bekannt ist, in welche Richtung die Schärfenebene für ein korrektes Fokussieren verstellt werden muss. Diese Informationen ergeben sich erst durch das Überfahren der Schärfenebene. Aufgrund der störenden Oszillation kommt ein Kontrast-Autofokus für qualitativ hochwertige Bewegtbildaufnahmen, wie etwa Kinoproduktionen, in der Regel nicht in Betracht.

Beim Autofokus mit PDAF-Pixeln bestehen diese Nachteile nicht, da aus den Daten des Bildsensors, mittels dessen die Bilder aufgenommen werden, direkt die relative Lage des Objektivs zur aktuellen Schärfenebene bestimmt werden kann. Allerdings muss der Bildsensor hierfür besondere Pixel, die genannten PDAF-Pixel, aufweisen. Ein solches PDAF-Pixel kann beispielsweise dadurch gebildet werden, dass mehrere gewöhnliche Pixel (beispielsweise zwei) unter einer gemeinsamen Mikrolinse angeordnet werden oder dadurch, dass ein Pixel durch eine Maskierung zur Hälfte abgedeckt wird. Denn beides ermöglicht es festzustellen, ob zwischen verschiedenen Bereichen (Hälften) der PDAF-Pixel eine Phasendifferenz der jeweils erzeugten Signale vorliegt, was ein Hinweis darauf ist, dass das entsprechende Motiv nicht im Fokus ist. Zugleich lässt sich anhand des Betrags und des Vorzeichens der Phasendifferenz bestimmen, um wie viel und in welche Richtung der Fokus verstellt werden muss, damit das Motiv scharf abgebildet wird.

Für die Anordnung der PDAF-Pixel auf dem Bildsensor gibt es verschiedene Strategien. Beispielsweise können mehrere einzelne Zeilen des Bildsensors vollständig oder zumindest größtenteils mit PDAF-Pixeln belegt werden. Alternativ dazu können die PDAF-Pixel verstreut angeordnet sein, d. h. dass einzelne PDAF-Pixel oder Paare von PDAF-Pixeln mit Abstand zueinander über den Bildsensor verteilt sind. Alternativ dazu ist es ferner bekannt, sämtliche Pixel eines Bildsensors als PDAF-Pixel auszubilden, nämlich entweder als Pixel-Paare, deren zwei Pixel unter einer gemeinsamen Mikrolinse angeordnet sind, oder als Gruppen von vier Pixeln in einer 2x2-Anordnung unter einer gemeinsamen Mikrolinse.

Dadurch, dass die PDAF-Pixel anders aufgebaut sind als die übrigen Pixel des Bildsensors, können sie, wenn sie, wie erläutert, zeilenweise oder verstreut angeordnet sind, (wenn überhaupt) nur sehr eingeschränkt zur mittels der anderen Pixel gewonnenen Bildinformation für das aufzunehmende Bild beitragen. In der Regel muss daher die Bildinformation an einem Bildpunkt, der einem PDAF-Pixel entspricht, interpoliert werden, als würde es sich bei dem PDAF-Pixel um einen defekten Pixel handeln. Bei sehr hohen Anforderungen an die Bildqualität kann häufig nicht einmal die Bildinformation der direkten Nachbarn eines PDAF-Pixels für die Interpolation herangezogen werden, da auch diese in ihren Eigenschaften von normalen Pixeln abweichen. Daher ist in Anwendungen, die hohe Qualität erfordern, eine zeilenweise oder verstreute Anordnung der PDAF-Pixel nicht verwendbar.

Bei vollflächiger Anordnung, wenn also alle Pixel des Bildsensors als PDAF-Pixel ausgebildet sind, werden diese zwar Nachteile vermieden. Allerdings wird dadurch die Datenrate, d. h. die Menge an Bildinformation, die zur Erzielung einer bestimmten Auflösung bei einer bestimmten Bildfrequenz pro Zeiteinheit verarbeitet werden muss, mindestens verdoppelt (ggf. sogar vervierfacht). Mit einer doppelten Datenrate geht auch eine Verdopplung der Verlustleistung einher. Denn es muss nicht nur die doppelte Datenmenge vom Sensor an eine nachgeordnete Verarbeitungselektronik ausgegeben werden, sondern diese doppelte Datenmenge muss dort auch prozessiert werden. Die dafür erforderliche Leistung führt auch zu einer Erhöhung der erzeugten Wärme, was für eine Kamera grundsätzlich problematisch ist. Heutzutage wird teilweise sogar die Baugröße einer Kamera in erheblichem Maße von der Größe ihres Kühlsystems bestimmt. Es wird daher angestrebt, die Datenrate möglichst gering zu halten.

Es ist eine Aufgabe der Erfindung, einen Bildsensor bereitzustellen, der eine besonders zuverlässige automatische Fokuseinstellung ermöglicht, nur eine vergleichsweise geringe Datenrate erfordert und auch ansonsten die genannten Nachteile möglichst vermeidet, so dass er insbesondere auch für das Aufnehmen von Bewegtbilddaten im Rahmen von Produktionen mit besonders hohem Qualitätsanspruch geeignet ist.

Die Aufgabe wird gelöst durch einen Bildsensor mit den Merkmalen des Anspruchs 1. Vorteilhafte Ausführungsformen ergeben sich aus den Unteransprüchen, der vorliegenden Beschreibung sowie der Figur.

Der erfindungsgemäße Bildsensor, bei dem es sich insbesondere um einen CMOS-Bildsensor handelt, ist als Bildsensor für eine elektronische Kamera, insbesondere für eine Bewegtbildkamera, ausgebildet und weist eine Vielzahl von in Zeilen und Spalten angeordneten Pixeln auf, von denen jedes einem von zumindest drei Farbkanälen zugeordnet ist.

Bei der Anordnung der Pixel in Zeilen und Spalten handelt es sich vorzugsweise um eine starre zweidimensionale Anordnung, bei der die Pixel regelmäßig voneinander beabstandet angeordnet sind. Die Anordnung kann insofern als Pixelmatrix betrachtet werden. Der Verlauf der Zeilen und der Verlauf der Spalten sind jeweils vorzugsweise geradlinig. Die Spalten sind vorzugsweise orthogonal zu den Zeilen ausgerichtet. Grundsätzlich können die Spalten aber auch schräg zu den Zeilen ausgerichtet sein. Die Anordnung der Pixel kann insbesondere eine zumindest im Wesentlichen rechteckige Form aufweisen. Zumindest innerhalb eines für die Aufnahme eines jeweiligen Bildes vorgesehenen Bildbereichs des Bildsensors, der ebenfalls insbesondere eine zunächst im Wesentlichen rechteckige Form aufweisen kann und grundsätzlich der gesamten Anordnung der Pixel entsprechen kann, bildet vorzugsweise jeder Matrixpunkt, d. h. jeder Kreuzungspunkt einer Zeile mit einer Spalte der Anordnung, einen Pixel. Zudem erstreckt sich vorzugweise kein Pixel über mehr als eine Zeile und auch kein Pixel über mehr als eine Spalte. (Dasselbe gilt somit auch für die Bestandteile eines jeweiligen Pixels, wie z. B. ein oder mehrere Detektorelemente, einen Farbfilter oder eine Mikrolinse des jeweiligen Pixels, auf die im Folgenden noch eingegangen wird.)

Vorzugsweise sind genau drei Farbkanäle vorgesehen. Bei den drei Farbkanälen kann es sich insbesondere um einen grünen Farbkanal, einen roten Farbkanal und einen blauen Farbkanal handeln. Grundsätzlich können aber auch mehr, insbesondere vier Farbkanäle vorgesehen sein. Beispielsweise kann neben einem grünen, einem roten und einem blauen Farbkanal ein weißer Farbkanal vorgesehen sein. Wenn von einem Pixel eines bestimmten Farbkanals die Rede ist, ist damit ein Pixel gemeint, das diesem Farbkanal zugeordnet ist.

Jedes Pixel umfasst zumindest ein lichtempfindliches Detektorelement, das dazu ausgebildet ist, in Abhängigkeit von auftreffendem Licht elektrische Signale zu erzeugen. Ein jeweiliges elektrisches Signal kann insbesondere in Form elektrischer Ladung vorliegen, die von dem Detektorelement in Abhängigkeit von auf das Detektorelement, insbesondere auf eine Detektionsfläche des Detektorelements, auftreffendem Licht erzeugt wird. Die erzeugte elektrische Ladung kann insbesondere von der Intensität bzw. Menge des auftreffenden Lichts innerhalb eines bestimmten Belichtungszeitraums abhängen. Am Ende des Belichtungszeitraums kann das elektrische Signal bzw. die elektrische Ladung aus dem Detektorelement ausgelesen werden, insbesondere von einer dazu vorgesehenen Ausleseelektronik des Bildsensors. Das Detektorelement kann insbesondere als sogenannte Pinned-Diode ausgebildet sind.

Außerdem umfasst jedes Pixel einen Farbfilter, welcher das Licht vor dem Auftreffen auf das zumindest eine Detektorelement gemäß dem Farbkanal, dem das jeweilige Pixel zugeordnet ist, filtert. Das heißt, dass der Farbfilter nur einen Teil des Lichts zum Detektorelement durchlässt, nämlich im Wesentlichen nur denjenigen Teil des Lichts, der innerhalb eines bestimmten Spektralbereich des (sichtbaren) Lichts liegt, der der Farbe des jeweiligen Farbkanals entspricht. Wenn das jeweilige Pixel mehrere Detektorelemente umfasst, erstreckt sich der Farbfilter des Pixels über diese mehreren Detektorelemente, so dass auf alle Detektorelemente eines jeweiligen Pixels nur Licht der Farbe auftrifft, die dem Farbkanal entspricht, dem das jeweilige Pixel zugeordnet ist.

Jedes Pixel kann darüber hinaus eine Mikrolinse umfassen, die entlang des Strahlengangs vor oder hinter dem Farbfilter angeordnet sein kann und dazu dienen kann, auf das jeweilige Pixel auftreffendes Licht zu sammeln. Wenn das jeweilige Pixel mehrere Detektorelemente umfasst, erstreckt sich die Mikrolinse des Pixels über diese mehreren Detektorelemente.

Erfindungsgemäß umfasst jedes Pixel, das einem ersten Farbkanal der drei Farbkanäle zugeordnet ist, genau zwei lichtempfindliche Detektorelemente, die dazu ausgebildet sind, unabhängig voneinander in Abhängigkeit von (auf das jeweilige Detektorelement) auftreffendem Licht elektrische Signale zu erzeugen, so dass eine Phasendifferenz zwischen den von den Detektorelementen des jeweiligen Pixels erzeugten elektrischen Signalen für eine Autofokusfunktion der Kamera nutzbar ist, wohingegen von den Pixeln, die nicht dem ersten Farbkanal zugeordnet sind, zumindest einige dieser Pixel, vorzugsweise die meisten, insbesondere alle dieser Pixel, nur ein einzelnes lichtempfindliches Detektorelement umfassen, das dazu ausgebildet ist, in Abhängigkeit von (auf das Detektorelement) auftreffendem Licht elektrische Signale zu erzeugen.

Wenn vier Farbkanäle vorgesehen sind, können auch die Pixel, die dem vierten Farbkanal zugeordnet sind, jeweils zwei Detektorelemente umfassen. Das kann insbesondere zweckmäßig sein, wenn es sich bei dem vierten Farbkanal um einen weißen Farbkanal handelt. Es kann aber auch bei mehr als drei Farbkanälen vorteilhaft sein, wenn nur die Pixel, die dem ersten Farbkanal zugeordnet sind, zwei Detektorelemente umfassen.

Die Bezeichnung eines jeweiligen Farbkanals als "erster", "zweiter", "dritter" oder "vierter" Farbkanal dient ausschließlich der sprachlichen Unterscheidung der Farbkanäle. Insbesondere soll diese Bezeichnung keine Hierarchie oder Reihenfolge zwischen den Farbkanälen implizieren. Grundsätzlich kommt jede beliebige Farbe als Farbe des ersten Farbkanals in Betracht. Sofern drei Farbkanäle vorgesehen sind, ist es besonders zweckmäßig, wenn es sich bei dem ersten Farbkanal um einen grünen Farbkanal handelt, wenn also jedes Pixel, das dem ersten Farbkanal zugeordnet ist, einen Farbfilter umfasst, der nur Licht eines grünen Spektralbereichs durchlässt.

Grundsätzlich ist, wenn ein Farbkanal als Farbkanal einer bestimmten Farbe (zum Beispiel "grüner Farbkanal") bezeichnet wird, damit gemeint, dass jedes Pixel, das diesem Farbkanal zugeordnet ist, einen Farbfilter der entsprechenden Farbe umfasst, also einen Farbfilter, der nur Licht eines der Farbe entsprechenden Spektralbereichs durchlässt, so dass das eine oder die mehreren Detektorelemente des jeweiligen Pixels in Abhängigkeit von auftreffendem Licht dieser Farbe elektrische Signale bzw. elektrische Ladung erzeugt/erzeugen.

Es ist bevorzugt, wenn die Detektorelemente eines jeweiligen Pixels separat voneinander angeordnet sind, also einander nicht überlappen. Die zwei Detektorelemente eines jeweiligen Pixels können insbesondere in einer Ebene des Bildsensors benachbart zueinander angeordnet sein und entlang einer vorzugsweise geraden Trennlinie, bevorzugt mit konstantem Abstand voneinander, aneinander angrenzen.

Dadurch, dass die Pixel, die dem ersten Farbkanal zugeordnet sind, zwei Detektorelemente umfassen, können sie als PDAF-Pixel verwendet werden, also als Pixel zur Bestimmung einer Fokusdistanz der Kamera. Hierfür kann, beispielsweise mittels einer zugeordneten Auswerteschaltung, eine Phasendifferenz zwischen den elektrischen Signalen bzw. elektrischen Ladungen ermittelt werden, die von den zwei Detektorelementen des jeweiligen Pixels erzeugt werden. Auf der Grundlage der ermittelten Phasendifferenz kann dann ein Steuersignal für den Objektivantrieb zur automatischen Fokussierung ermittelt werden kann.

Im Unterschied zu den Pixeln, die dem ersten Farbkanal zugeordnet sind, umfasst jedenfalls ein (überwiegender) Teil der Pixel, die nicht dem ersten Farbkanal zugeordnet sind, lediglich ein Detektorelement. Diese Pixel eignen sich daher nicht als PDAF-Pixel und tragen somit nicht zum Autofokus bei, sondern dienen vorzugweise ausschließlich der Bilderzeugung. Die Pixel, die nicht dem ersten Farbkanal zugeordnet sind, sind einem der übrigen Farbkanäle, bei insgesamt drei Farbkanälen also entweder einem zweiten Farbkanal oder einem dritten Farbkanal, zugeordnet. Sofern mehr als drei Farbkanäle vorgesehen sind, können die Pixel, die einem vierten Farbkanal zugeordnet sind, entweder ähnlich wie die Pixel, die dem ersten Farbkanal zugeordnet sind, ausgebildet sein, nämlich zumindest zwei Detektorelemente umfassen, oder wie die Pixel, die dem zweiten Farbkanal oder dem dritten Farbkanal zugeordnet sind, ausgebildet sein, also insbesondere lediglich ein Detektorelement umfassen.

Ob ein jeweiliges Pixel des Bildsensors zwei Detektorelemente aufweist und somit als PDAF-Pixel verwendet werden kann oder nicht, hängt bei dem erfindungsgemäßen Bildsensor folglich nicht primär von der Position des jeweiligen Pixels auf dem Bildsensor ab, sondern davon, welchem Farbkanal das jeweilige Pixel zugeordnet ist. Da einem jeweiligen Farbkanal in der Regel nicht weniger als 25 % und nicht mehr als 50 % aller Pixel des Bildsensors zugeordnet sind, weist der erfindungsgemäße Bildsensor anders als bekannte Bildsensoren mit PDAF-Pixeln nicht lediglich einige wenige, z. B. zeilenweise oder verstreut angeordnete, PDAF-Pixel auf und ist auch nicht vollflächig mit PDAF-Pixeln ausgestattet. Die PDAF-Pixel des erfindungsgemäßen Bildsensors brauchen ähnlich wie bei einer vollflächigen Anordnung von PDAF-Pixeln nicht interpoliert zu werden, sondern können aufgrund ihrer Ausbildung mit zwei Detektorelementen zur Bildinformation durchaus beitragen. Im Unterschied zu einer vollflächigen Anordnung wird aber die Datenrate nicht verdoppelt oder vervierfacht, sondern erhöht sich vergleichsweise geringfügig.

Beispielsweise erhöht sich bei einem Bildsensor, bei dem die Farbfilter der Pixel gemäß einer Bayer-Maske angeordnet sind, die Datenrate nur auf 150 %, wenn es sich bei dem ersten Farbkanal um den grünen Farbkanal handelt, dem bei einer Bayer-Maske 50 % der Pixel zugeordnet sind. Durch eine derart moderate Erhöhung lassen sich wesentliche Nachteile im Betrieb des Bildsensors vermeiden. Da der grüne Farbkanal darüber hinaus im Vergleich zu den beiden weiteren Farbkanäle (rot und blau) typischerweise eine deutlich höhere Lichtempfindlichkeit aufweist, die zum Beispiel 180 % der Lichtempfindlichkeit des roten Farbkanals betragen kann, sind die verschiedenen Farbkanäle dadurch, dass die dem grünen Farbkanal zugeordneten Pixel zwei Detektorelemente umfassen, auf die jeweils nur etwa die Hälfte der auf das gesamte Pixel auftreffenden Lichtmenge auftrifft, dann sogar besser aneinander angepasst als bei einem herkömmlichen Bildsensor mit Bayer-Maske.

Bei einigen Ausführungsformen sind die Pixel des Bildsensors an Positionen angeordnet, die ein regelmäßiges Raster von Zeilen und Spalten bilden, wobei die zumindest zwei lichtempfindlichen Detektorelemente der Pixel des ersten Farbkanals gemeinsam an einer einzigen Position des Rasters angeordnet sind. Dementsprechend kann auch jede Mikrolinse des Bildsensors an genau einer jeweiligen Position des Rasters angeordnet sein.

Gemäß einer vorteilhaften Ausführungsform ist zumindest die Hälfte der Pixel des Bildsensors dem ersten Farbkanal zugeordnet. Durch eine solche hohe Zahl an Pixeln, die als PDAF-Pixel für einen Autofokus genutzt werden können, kann der Autofokus besonders zuverlässig erfolgen.

Insbesondere kann genau die Hälfte der Pixel des Bildsensors dem ersten Farbkanal zugeordnet sein. Beispielweise können sich gemäß einer weiteren vorteilhaften Ausführungsform in jeder Zeile und jeder Spalte des Bildsensors (entlang des Verlaufs der jeweiligen Zeile bzw. jeweiligen Spalte) Pixel, die dem ersten Farbkanal zugeordnet sind, mit Pixeln, die nicht dem ersten Farbkanal zugeordnet sind, abwechseln. Folglich sind die Pixel, die dem ersten Farbkanal zugeordnet sind, gemäß einem Muster angeordnet, das der Anordnung der schwarzen Felder auf einem Schachbrett entspricht. Dadurch sind die zum Autofokus beitragenden Pixel des ersten Farbkanals und die übrigen Pixel, die vorzugsweise ausschließlich zur Bildaufnahme beitragen, homogen über den Bildsensor verteilt. Auf diese Weise lassen sich, insbesondere richtungsabhängige, Artefakte an Übergängen zwischen Pixeln der einen Art und Pixeln der anderen Art vermeiden.

Gemäß einer vorteilhaften Weiterbildung der vorstehenden Ausführungsform sind die Pixel, die nicht dem ersten Farbkanal zugeordnet sind, zeilenweise abwechselnd einem zweiten Farbkanal bzw. einem dritten Farbkanal zugeordnet. (Die Pixel, die nicht dem ersten Farbkanal zugeordnet sind, sind dadurch zwangsläufig auch spaltenweise abwechselnd dem zweiten Farbkanal bzw. dem dritten Farbkanal zugeordnet.) Mit anderen Worten: In jeder zweiten Zeile (bzw. Spalte) des Bildsensors sind die Pixel, die nicht dem ersten Farbkanal zugeordnet sind, dem zweiten Farbkanal zugeordnet und in den übrigen Zeilen (bzw. Spalten) des Bildsensors sind die Pixel, die nicht dem ersten Farbkanal zugeordnet sind, dem dritten Farbkanal zugeordnet.

Während es sich bei dem ersten Farbkanal vorzugsweise um einen grünen Farbkanal handelt, handelt es sich bei dem zweiten Farbkanal vorzugsweise um einen roten Farbkanal und bei dem dritten Farbkanal vorzugsweise um einen blauen Farbkanal. Wenn die Pixel des Bildsensors diesen drei Farbkanälen gemäß dem vorstehend beschriebenen Schema zugeordnet sind, entspricht diese Anordnung einer sogenannten Bayer-Maske. Die Bildpunkte eines mittels des Bildsensors aufgenommenen Bildes im RAW-Format sind dann ebenfalls entsprechend der Bayer-Maske den drei Farbkanäle zugeordnet. Das erlaubt vorteilhafterweise die Anwendung etablierter Interpolationsalgorithmen für ein sogenanntes Demosaicing der RAW-Bilddaten.

Gemäß einer Ausführungsform weist jedes Detektorelemente eine Detektionsfläche auf, auf die das Licht auftrifft. In Abhängigkeit von dem auf diese Detektionsfläche auftreffenden Licht erzeugt das jeweilige Detektorelement die genannte elektrische Ladung bzw. das genannte elektrische Signal. Die Detektionsfläche kann insbesondere dadurch definiert sein, dass nur Licht, das auf diese Fläche des Detektorelements trifft, zur Signal- bzw. Ladungserzeugung beiträgt.

Bei einigen Ausführungsformen kann für jedes Pixel, das dem ersten Farbkanal zugeordnet ist, die Summe der Detektionsflächen der zumindest zwei Detektorelemente des jeweiligen Pixels größer sein als die Detektionsfläche eines Detektorelements eines Pixels, das nicht dem ersten Farbkanal zugeordnet ist und nur ein einzelnes Detektorelement umfasst. Somit ist bei Pixeln, die dem ersten Farbkanal zugeordnet sind, die effektive Detektionsfläche größer als bei Pixeln, die nur ein einzelnes Detektorelement umfassen. Das kann insbesondere dann zweckmäßig sein, wenn es sich bei dem ersten Farbkanal um einen grünen Farbkanal handelt, während es sich bei dem zweiten und dritten Farbkanal um einen roten bzw. blauen Farbkanal handelt. Denn Pixel des grünen Farbkanals weisen in der Regel eine deutliche höhere Lichtempfindlichkeit als Pixel des blauen oder roten Farbkanals auf. Durch die größere Gesamtdetektionsfläche bei den Pixeln des ersten (grünen) Farbkanals wird die sogenannte Full-Well-Kapazität der Detektorelemente eines jeweiligen Pixel des ersten (grünen) Farbkanals erhöht und ist damit besser an die Full-Well-Kapazität des Detektorelements eines jeweiligen Pixels des zweiten (roten) oder dritten (blauen) Farbkanals angeglichen.

Bei einigen Ausführungsformen kann für jedes Pixel, das dem ersten Farbkanal zugeordnet ist, die jeweilige Detektionsfläche der zwei Detektorelemente des jeweiligen Pixels jedoch geringer sein als die Detektionsfläche eines Detektorelements eines Pixels, das nicht dem ersten Farbkanal zugeordnet ist und nur ein einzelnes Detektorelement umfasst.

Erfindungsgemäß umfasst jedes Pixel, das dem ersten Farbkanal zugeordnet ist, genau zwei Detektorelemente, wobei jedes Pixel, das dem ersten Farbkanal zugeordnet ist, eine Gesamtfläche aufweist, die entlang einer jeweiligen Teilungsrichtung in zwei Hälften geteilt ist, wobei in der einen Hälfte das eine Detektorelement des jeweiligen Pixels angeordnet ist und in der anderen Hälfte das andere Detektorelement des jeweiligen Pixels angeordnet ist. Mit anderen Worten: Bei den Pixeln, die dem ersten Farbkanal zugeordnet sind, sind die zwei Detektorelemente des jeweiligen Pixels auf zwei Hälften der Gesamtfläche des jeweiligen Pixels verteilt angeordnet, die sich durch Aufteilung der Gesamtfläche entlang einer jeweiligen Teilungsrichtung ergeben.

Die genannte Gesamtfläche eines Pixels kann zum Beispiel zumindest im Wesentlichen als die Schnittfläche der jeweiligen Zeile und der jeweiligen Spalte des Bildsensors definiert sein, in denen das jeweilige Pixel liegt. Die Gesamtfläche muss aber nicht unbedingt rechteckig sein, sondern kann zu einem Kreis abgerundet sein oder abgeflachte Ecken aufweisen und somit beispielsweise achteckig sein.

Die jeweilige Teilungsrichtung, entlang welcher die Gesamtfläche eines jeweiligen Pixels in zwei Hälften geteilt ist, ist nicht für alle Pixel, die dem ersten Farbkanal zugeordnet sind, dieselbe. Erfindungsgemäß sind jedoch alle Pixel, die dem ersten Farbkanal zugeordnet sind, entlang einer von genau zwei definierten Teilungsrichtungen geteilt, die bevorzugt orthogonal zueinander ausgerichtet sind. Die Gesamtflächen zumindest etwa der Hälfte der dem ersten Farbkanal zugeordneten Pixel können jeweils entlang einer ersten Teilungsrichtung dieser zwei Teilungsrichtungen in zwei Hälften geteilt sein und die Gesamtflächen der übrigen dem ersten Farbkanal zugeordneten Pixel können jeweils entlang einer zweiten Teilungsrichtung dieser zwei Teilungsrichtungen in zwei Hälften geteilt sein.

Erfindungsgemäß ist für alle dem ersten Farbkanal zugeordneten Pixel die jeweilige Teilungsrichtung zum Verlauf der Zeilen und zum Verlauf der Spalten des Bildsensors diagonal ausgerichtet. Dass eine jeweilige Teilungsrichtung zum Verlauf der Zeilen und zum Verlauf der Spalten des Bildsensors diagonal ausgerichtet ist, meint insbesondere, dass sie weder parallel zum Verlauf der Zeilen noch parallel zum Verlauf der Spalten ist. Die jeweilige Teilungsrichtung kann beispielsweise in einem Winkel von 45° zum Verlauf der Zeilen und/oder zum Verlauf der Spalten ausgerichtet sein und insbesondere einer Winkelhalbierenden dieser beiden Verläufe entsprechen.

Dass eines der Detektorelemente des jeweiligen Pixels in einer der Hälften der Gesamtfläche des jeweiligen Pixels angeordnet ist, meint insbesondere, dass dieses Detektorelement ausschließlich innerhalb dieser Hälfte angeordnet ist. Beispielsweise kann die genannte Detektionsfläche des jeweiligen Detektorelements die jeweilige Hälfte zumindest weitgehend ausfüllen. Des Weiteren können die (Detektionsflächen der) beiden Detektorelemente eines jeweiligen dem ersten Farbkanal zugeordneten Pixels entlang der jeweiligen Teilungsrichtung zumindest im Wesentlichen aneinander angrenzen, zum Beispiel nur durch einen Spalt konstanter Breite voneinander getrennt sein.

Erfindungsgemäß weist jedes Pixel, das dem ersten Farbkanal zugeordnet ist, eine Gesamtfläche auf, die zeilenweise (ggf. auch spaltenweise) abwechselnd entlang einer ersten Teilungsrichtung oder einer zur ersten Teilungsrichtung quer, insbesondere orthogonal, ausgerichteten zweiten Teilungsrichtung in zwei Hälften geteilt ist, wobei in der einen Hälfte das eine Detektorelement des jeweiligen Pixels angeordnet ist und in der anderen Hälfte das andere Detektorelement des jeweiligen Pixels angeordnet ist. Mit anderen Worten: Bei den Pixeln, die dem ersten Farbkanal zugeordnet sind, sind in jeder zweiten Zeile die zwei Detektorelemente des jeweiligen Pixels auf zwei Hälften der Gesamtfläche des jeweiligen Pixels verteilt angeordnet, die sich durch Aufteilung der Gesamtfläche entlang der ersten Teilungsrichtung ergeben, und sind in jeder übrigen Zeile die zwei Detektorelemente des jeweiligen Pixels auf zwei Hälften der Gesamtfläche des jeweiligen Pixels verteilt angeordnet, die sich durch Aufteilung der Gesamtfläche entlang der zu der ersten Teilungsrichtung quer, insbesondere orthogonal, ausgerichteten zweiten Teilungsrichtung ergeben. Dabei ist vorgesehen, dass die erste Teilungsrichtung zum Verlauf der Zeilen und zum Verlauf der Spalten diagonal ausgerichtet ist und dass die zweite Teilungsrichtung zum Verlauf der Zeilen und zum Verlauf der Spalten diagonal ausgerichtet ist.

Wenn das mittels des Bildsensors aufgenommene Motiv Linien oder Kanten aufweist, die parallel zu der Teilungsrichtung verlaufen, entlang welcher ein jeweiliges dem ersten Farbkanal zugeordnetes (und somit als PDAF-Pixel fungierendes) Pixel geteilt ist, dann kann es sein, dass sich aus der Phasendifferenz zwischen den elektrischen Signalen bzw. elektrischen Ladungen der zwei Detektorelemente dieses Pixels keine Fokusinformation ableiten lässt. Dadurch jedoch, dass die Trennlinie zwischen den zwei Detektorelementen eines jeweiligen dem ersten Farbkanal zugeordneten Pixels abwechselnd in die erste Teilungsrichtung oder in die dazu quer, insbesondere orthogonal, ausgerichtete zweite Teilungsrichtung ausgerichtet ist, kann dieses Problem umgangen werden, da sich die Fokusinformation, wenn nicht anhand eines entlang der ersten Teilungsrichtung geteilten Pixels, dann aber anhand eines entlang der zweiten Teilungsrichtung geteilten Pixels feststellen lässt. Zweckmäßigerweise sind die entlang der ersten Teilungsrichtung geteilten Pixel und die entlang der zweiten Teilungsrichtung geteilten Pixel dabei, wie erläutert, zeilenweise und zeilenweise abwechselnd angeordnet und somit homogen auf dem Bildsensor verteilt. Denn durch diese Anordnung sind die nächsten Nachbarn eines entlang der ersten Teilungsrichtung geteilten Pixels entlang der zweiten Teilungsrichtung geteilt und umgekehrt die nächsten Nachbarn eines entlang der zweiten Teilungsrichtung geteilten Pixels entlang der ersten Teilungsrichtung geteilt, so dass sich in jedem Bereich des Bildsensors die für den Autofokus benötigte Information zuverlässig anhand der dem ersten Farbkanal zugeordneten Pixel ermitteln lässt.

Des Weiteren sind erfindungsgemäß zwischen den Pixeln Zwischenräume vorgesehen, an die jeweils vier Pixel angrenzen, wobei der Bildsensor eine Ausleseelektronik umfasst, die sich in diese Zwischenräume erstreckt. Der genannte Zwischenraum ist somit von vier Pixeln umgeben, die an den Zwischenraum angrenzen. Vorzugsweise handelt es sich für jeden der Zwischenräume um: zwei Pixel, die dem ersten Farbkanal zugeordnet sind, ein Pixel, dass dem zweiten Farbkanal zugeordnet ist, sowie ein Pixel, dass dem dritten Farbkanal zugeordnet ist. Die vier Pixel sind als Viereck, insbesondere als Quadrat, angeordnet, so dass sich also zwei der vier Pixel in derselben Zeile befinden und sich die anderen zwei Pixel in derselben dazu benachbarten Zeile befinden (bzw. dass sich zwei der vier Pixel in derselben Spalte befinden und sich die anderen zwei Pixel in derselben dazu benachbarten Spalte befinden).

Ferner weist erfindungsgemäß jedes Detektorelement ein Transfergate auf, an dem eine von dem Detektorelement erzeugte elektrische Ladung an die Ausleseelektronik ausgebbar ist, wobei an jeden Zwischenraum mindestens ein Transfergate eines Detektorelements eines an den Zwischenraum angrenzenden Pixels und höchstens ein weiteres Transfergate eines Detektorelements eines weiteren an den Zwischenraum angrenzenden Pixels angrenzen. D. h. es kann auch kein weiteres Transfergate an den jeweiligen Zwischenraum angrenzen. Mit anderen Worten: An jeden Zwischenraum grenzt/grenzen entweder genau ein Transfergate oder genau zwei Transfergates an, wobei es sich bei den zwei Transfergates um Transfergates verschiedener an den Zwischenraum angrenzender Pixel handelt. Jedes Transfergate kann insbesondere in einem von vier zum Verlauf der Zeilen und Spalten diagonal ausgerichteten Eckbereichen des jeweiligen Pixels (d. h. des Pixels, von dem das Detektorelement mit dem Transfergate umfasst wird) angeordnet sein. Gängige alternative Bezeichnungen für Transfergate sind Transmission-Gate oder Übertragungsgatter.

Insbesondere ist es bevorzugt, wenn sich sowohl entlang des Verlaufs der Zeilen als auch entlang des Verlaufs der Spalten des Bildsensors Zwischenräume, an die genau ein Transfergate angrenzt, mit Zwischenräumen, an die zwei Transfergates angrenzen, gerade abwechseln.

Des Weiteren sind erfindungsgemäß für jedes Pixel, das dem ersten Farbkanal zugeordnet ist und dessen Gesamtfläche entlang der ersten Teilungsrichtung geteilt ist, die Transfergates seiner zwei Detektorelemente bezüglich der zweiten Teilungsrichtung entgegengesetzt zueinander angeordnet; und sind gerade umgekehrt für jedes Pixel, das dem ersten Farbkanal zugeordnet ist und dessen Gesamtfläche entlang der zweiten Teilungsrichtung geteilt ist, die Transfergates seiner zwei Detektorelemente bezüglich der ersten Teilungsrichtung entgegengesetzt zueinander angeordnet. Insbesondere können die Transfergates dazu in denjenigen zwei der vier Eckbereiche des jeweiligen Pixels angeordnet sein, die bezüglich der jeweiligen Teilungsrichtung entgegengesetzt zueinander sind. Ferner ist erfindungsgemäß vorgesehen, dass für jedes Pixel, das nicht dem ersten Farbkanal zugeordnet ist, das Transfergate seines Detektorelements in die erste Teilungsrichtung weisend angeordnet ist. Insbesondere kann das Transfergate dazu in demjenigen der vier Eckbereiche des jeweiligen Pixels angeordnet sein, der in die erste Teilungsrichtung weist. Auf diese Weise wird eine ausgeglichene Anordnung der Transfergates erreicht, bei der die Ausleseelektronik in den Zwischenräumen zwischen den Pixeln jeweils nur entweder ein oder zwei Transfergates auslesen muss.

Gemäß einer weiteren Weiterbildung vorstehender Ausführungsformen umfasst die Ausleseelektronik eine Vielzahl von Sourcefolger-Transistoren und ist jedes Transfergate mit einem der Sourcefolger-Transistoren elektrisch verbunden, so dass über den Sourcefolger-Transistor die von dem jeweiligen Detektorelement (d. h. von demjenigen Detektorelement, welches das Transfergate aufweist) erzeugte elektrische Ladung auslesbar ist, wobei für zwei Transfergates, die an denselben Zwischenraum angrenzen, jeweils beide Transfergates mit demselben Sourcefolger-Transistor elektrisch verbunden sind, so dass die von den jeweiligen Detektorelementen (d. h. von denjenigen Detektorelementen, welche ein jeweiliges der zwei Transfergates aufweisen) erzeugte elektrische Ladung über einen einzelnen gemeinsamen Sourcefolger-Transistor (nämlich den genannten Sourcefolger-Transistor, mit dem beide Sourcefolger-Transistoren elektrisch verbunden sind) auslesbar ist. In denjenigen Zwischenräumen, an die zwei Transfergates angrenzen, ist also eine sogenannte 2x-Shared-Pixel-Architektur vorgesehen, bei welcher die Ladung zweier Pixel, über einen gemeinsamen Sourcefolger-Transistor ausgelesen werden. Eine solche Architektur ist insbesondere aus Platzgründen vorteilhaft.

Als Sourcefolger-Transistor wird ein Feldeffekttransistor bezeichnet, der in einer Sourcefolger-Schaltung (auch als Common-Drain-Schaltung bezeichnet) verschaltet ist. Mit dem Sourcefolger-Transistor kann auch die gesamte Sourcefolger-Schaltung (Common-Drain-Schaltung) gemeint sein. Die Transfergates sind mit dem Eingang der jeweiligen Sourcefolger-Schaltung (Common-Drain-Schaltung) elektrisch verbunden.

Die Erfindung wird nachfolgend lediglich beispielhaft anhand der Figur weiter erläutert.

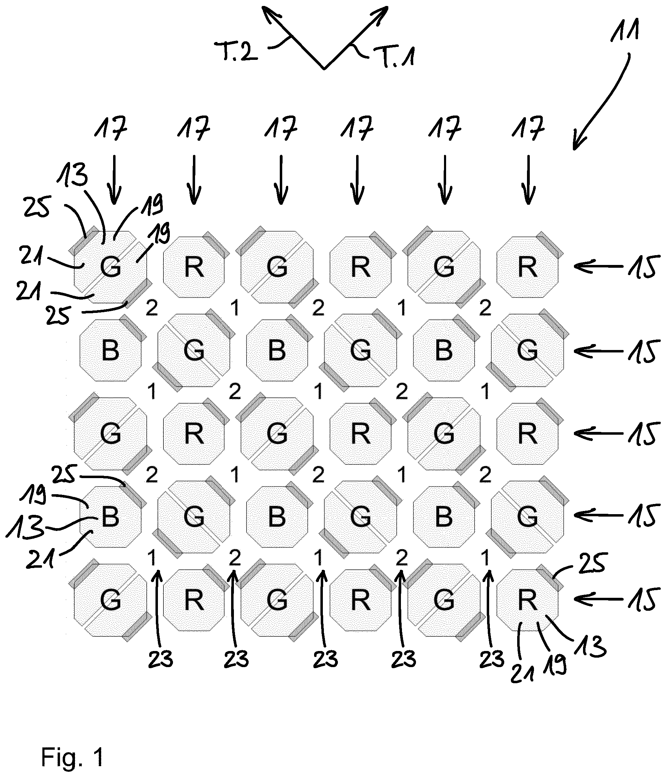

- Fig. 1: zeigt einen Ausschnitt eines gemäß einer möglichen Ausführungsform der Erfindung ausgebildeten Bildsensors in schematischer Darstellung.

Der in Fig. 1 dargestellte Bildsensor 11 ist als CMOS-Bildsensor ausgebildet und kann insbesondere als Bildsensor für eine elektronische Kamera (nicht dargestellt) verwendet werden. Der Bildsensor 11 umfasst eine Vielzahl von Pixeln 13, die als eine Pixelmatrix in Zeilen 15 und Spalten 17 angeordnet sind. Die Zeilen 15, die in Fig. 1 horizontal verlaufen, und die Spalten 17, die in Fig. 1 vertikal verlaufen, weisen jeweils einen geradlinigen Verlauf auf und sind hinsichtlich ihres jeweiligen Verlaufs orthogonal zueinander ausgerichtet.

Der Bildsensor 11 kann beispielsweise eine 4K-Auflösung oder eine noch höhere Auflösung aufweisen. Somit kann der Bildsensor 11 beispielsweise 4096 Spalten 17 und je nach Format eine entsprechende Anzahl von Zeilen 15, zum Beispiel 3072 oder 2304 Zeilen 15, aufweisen. Die jeweilige Höhe der Zeilen 15 und die jeweilige Breite der Spalten 17 sind vorzugsweise identisch. In Fig. 1 ist lediglich ein Ausschnitt des Bildsensors 11 gezeigt, der fünf Zeilen 15 und sechs Spalten 17 umfasst. Anhand dieses Ausschnitts lässt sich das Muster nachvollziehen, gemäß dem die Pixel 13 auf dem gesamten Bildsensor 11 angeordnet sind.

Der Bildsensor 11 weist drei Farbkanäle auf, nämlich einen ersten Farbkanal G, bei dem es sich um einen grünen Farbkanal handelt, einen zweiten Farbkanal R, bei dem es sich um einen roten Farbkanal handelt, sowie einen dritten Farbkanal B, bei dem es sich um einen blauen Farbkanal handelt. Jedes Pixel 13 des Bildsensor 11 ist einem dieser drei Farbkanäle G, R, B zugeordnet. Die dem ersten Farbkanal G zugeordneten Pixel 13 sind in Fig. 1 durch ein "G" gekennzeichnet, die dem zweiten Farbkanal R zugeordneten Pixel 13 sind in Fig. 1 durch ein "R" gekennzeichnet und die dem dritten Farbkanal B zugeordneten Pixel 13 sind in Fig. 1 durch ein "B" gekennzeichnet.

Wie in Fig. 1 zu erkennen ist, wechseln sich in jeder Zeile 15 und jeder Spalte 17 des Bildsensors 11 Pixel 13, die dem ersten Farbkanal G zugeordnet sind, mit Pixeln 13, die dem zweiten Farbkanal R oder dem dritten Farbkanal B zugeordnet sind, ab. Dadurch sind die dem ersten Farbkanal G zugeordneten Pixel 13 schachbrettartig angeordnet. Folglich ist jedes zweite Pixel 13 des Bildsensors 11 dem ersten Farbkanal G zugeordnet.

Die Pixel 13, die nicht den ersten Farbkanal G zugeordnet sind, sind zeilenweise abwechselnd dem zweiten Farbkanal R oder dem dritten Farbkanal B zugeordnet. Aufgrund der schachbrettartigen Anordnung der dem ersten Farbkanal G zugeordneten Pixel 13 gilt dies auch spaltenweise. So befinden sich die dem zweiten Farbkanal R zugeordneten Pixel 13 in dem in Fig. 1 gezeigten Ausschnitt in der ersten, der dritten und der fünften Zeile 15 sowie in der zweiten, der vierten und der sechsten Spalte 17; die dem dritten Farbkanal B zugeordneten Pixel 13 befinden sich in dem in Fig. 1 gezeigten Ausschnitt in der zweiten und der vierten Zeile 15 sowie in der ersten, der dritten und der fünften Spalte 17.

Die beschriebene räumliche Anordnung der dem ersten Farbkanal G, dem zweiten Farbkanal R bzw. dem dritten Farbkanal B zugeordneten Pixel 13 entspricht einer sogenannten Bayer-Maske, die für Bildsensoren 11 allgemein verbreitet ist. Dadurch ist der Bildsensor 11 mit gängigen RAW-Workflows kompatibel.

Jedes Pixel 13 umfasst zumindest ein lichtempfindliches Detektorelement 19, das dazu ausgebildet ist, in Abhängigkeit von auf eine Detektionsfläche 21 des jeweiligen Detektorelements 19 auftreffendem Licht elektrische Signale in Form elektrischer Ladung zu erzeugen. Alle Detektorelemente 19 der Pixel 13 sind mit ihren Detektionsflächen 21 in einer gemeinsamen Ebene des Bildsensors 11 angeordnet.

Sofern ein jeweiliges Pixel 13 ein einzelnes Detektorelement 19 umfasst, ist dessen Detektionsfläche 21 zumindest annähernd rund, nämlich bei der gezeigten Ausführungsform achteckig. Bei Pixeln 13, die zwei Detektorelemente 19 umfassen, sind die beiden Detektionsflächen 21 dieser Detektorelemente 19 gemeinsam zumindest annähernd rund, nämlich bei der gezeigten Ausführungsform achteckig, wobei zwischen den beiden Detektionsflächen 21 ein schmaler geradliniger Spalt konstanter Breite verläuft. Insbesondere aufgrund der annähernd runden Form der Pixel 13 weist der Bildsensor 11 zwischen den Pixeln 13 Zwischenräume 23 auf. Jeder Zwischenraum 23 ist von vier Pixeln 13 umgeben, so dass diese vier Pixel 13 (mit einem jeweiligen Eckbereich) an den jeweiligen Zwischenraum 23 angrenzen.

Jedes Detektorelement 19 weist zudem ein Transfergate 25 auf, welches in eine bezüglich des Verlaufs der Zeilen 15 und Spalten 17 diagonale Richtung weisend (nämlich in einem der jeweils vier Eckbereiche des jeweiligen Pixels 13) angeordnet ist und an dem eine von dem Detektorelement 19 erzeugte elektrische Ladung an eine Ausleseelektronik des Bildsensors 11 ausgegeben werden kann. Zu diesem Zweck erstreckt sich die (nicht dargestellte) Ausleseelektronik in die genannten Zwischenräume 23.

Von jedem Pixel 13 sind in Fig. 1 jeweils nur das eine bzw. die zwei Detektorelemente 19 dargestellt. Von jedem Detektorelement 19 ist jeweils dessen Detektionsfläche 21 umrandet und hellgrau eingefärbt dargestellt, während das jeweilige Transfergate 25 als dunkelgrau eingefärbter Streifen dargestellt ist.

Des Weiteren umfasst jedes Pixel 13 einen Farbfilter, der nur Licht der dem jeweiligen Farbkanal G, R bzw. B, dem das jeweilige Pixel 13 zugeordnet ist, entsprechenden Farbe zu dem Detektorelement 19 bzw. den beiden Detektorelementen 19 des jeweiligen Pixels 13 durchlässt. Auf diese Weise trifft nur derjenige Anteil des Lichts auf das Detektorelement 19 bzw. die Detektorelemente 19 eines jeweiligen Pixels 13, der die dem jeweiligen Farbkanal G, R bzw. B entsprechende Farbe aufweist, so dass auch das von dem Detektorelement 19 bzw. den Detektorelementen 19 erzeugte Signal nur von der Intensität dieses Anteils des Lichts abhängig ist. Ferner umfasst jedes Pixel 13 eine Mikrolinse, die sich über das Detektorelement 19 bzw. die beiden Detektorelemente 19 des jeweiligen Pixels 13 erstreckt und das eintreffende Licht sammelt. Der Farbfilter und die Mikrolinse eines jeweiligen Pixels 13 sind in Fig. 1 nicht dargestellt.

Gemäß der Erfindung umfassen alle Pixel 13 des Bildsensors 11, die dem ersten Farbkanal G zugeordnet sind, jeweils zwei Detektorelemente 19. Die Pixel 13 des Bildsensors 11, die dem zweiten Farbkanal R oder dem dritten Farbkanal B zugeordnet sind, umfassen dagegen jeweils lediglich ein einzelnes Detektorelement 19. Dadurch können die dem ersten Farbkanal G zugeordneten Pixel 13 als PDAF-Pixel genutzt werden, indem eine Phasendifferenz zwischen den von den beiden Detektorelementen 19 des jeweiligen Pixels 13 erzeugten elektrischen Signalen gebildet wird, die zur Ermittlung einer Fokuseinstellung herangezogen werden kann, gemäß der ein Objektivantrieb der Kamera für eine automatische Fokussierung des Objektivs anzusteuern ist. Hierfür kann dem Bildsensor 11 eine Auswerteschaltung (nicht gezeigt) zugeordnet sein, die dazu ausgebildet ist, aus den Signalen der zwei Detektorelemente 19 des jeweiligen Pixels 13 eine Phasendifferenz zu bestimmen. Die Auswerteschaltung kann ferner dazu ausgebildet ist, aus der Phasendifferenz eine Information über eine Fokusdistanz des Bildsensors 11 bzw. der Kamera zu bestimmen. Die Auswerteschaltung kann in den Bildsensor 11 integriert oder hiervon separat ausgebildet sein, insbesondere als analoge oder digitale Schaltung. Die Auswerteschaltung kann mit der genannten Ausleseelektronik verbunden sein.

Bei jedem Pixel 13, das dem ersten Farbkanal G zugeordnet ist, sind die zwei Detektorelemente 19 des jeweiligen Pixels 13 auf zwei Hälften der Gesamtfläche des jeweiligen Pixels 13 verteilt angeordnet, die sich durch Aufteilung der Gesamtfläche entweder entlang einer zum Verlauf der Zeilen 15 und zum Verlauf der Spalten 17 diagonal ausgerichteten ersten Teilungsrichtung T.1 (vgl. Pfeil) oder entlang einer zum Verlauf der Zeilen 15 und zum Verlauf der Spalten 17 diagonal ausgerichteten zweiten Teilungsrichtung T.2 (vgl. Pfeil) ergeben. Beide Teilungsrichtungen T.1 und T.2 weisen jeweils einen Winkel von 45° sowohl zum Verlauf der Zeilen 15 als auch zum Verlauf der Spalten 17 des Bildsensors 11 auf, wobei die erste Teilungsrichtung T.1 orthogonal zur zweiten Teilungsrichtung T.2 ausgerichtet ist.

In welche der beiden Teilungsrichtungen T.1 und T.2 ein jeweiliges dem ersten Farbkanal G zugeordnetes Pixel 13 geteilt ist, hängt von der Zeile 15 bzw. Spalte 17 ab, in der sich dieses Pixel 13 befindet. In jeder zweiten Zeile 15 (in Fig. 1 in der ersten, der dritten und der fünften Zeile 15) bzw. in jeder zweiten Spalte 17 (in Fig. 1 in der ersten, der dritten und der fünften Spalte 17) sind die dem ersten Farbkanal G zugeordneten Pixel 13 entlang der ersten Teilungsrichtung T.1 geteilt, während sie in den anderen Zeilen 15 (in Fig. 1 in der zweiten und der vierten Zeile 15) bzw. in den anderen Spalten 17 (in Fig. 1 in der zweiten, der vierten und der sechsten Spalte 17) entlang der zweiten Teilungsrichtung T.2 geteilt sind. Die zeilen- und spaltenweise abwechselnde Teilung der als PDAF-Pixel nutzbaren Pixel 13 des ersten Farbkanals G in die zwei zueinander orthogonalen Teilungsrichtungen T.1 und T.2 verhindert, dass der auf der Phasendifferenz zwischen den Signalen zweier Detektorelemente 19 eines jeweiligen Pixels 13 beruhende Autofokus in Bereichen des Motivs, die ein Linienmuster oder Kanten aufweisen, unter Umständen nicht funktioniert.

Während bei jedem Pixel 13, das dem zweiten Farbkanal R oder dem dritten Farbkanal B zugeordnet ist, das Transfergate 25 des Detektorelements 19 in die erste Teilungsrichtung T.1 weisend angeordnet ist, hängt bei den Pixeln 13, die dem ersten Farbkanal G zugeordnet sind, die Anordnung der Transfergates 25 seiner zwei Detektorelemente 19 davon ab, entlang welcher der beiden Teilungsrichtungen T.1 und T.2 das jeweilige Pixel 13 geteilt ist. Wenn das Pixel 13 entlang der ersten Teilungsrichtung T.1 geteilt ist, sind die Transfergates 25 seiner zwei Detektorelemente 19 bezüglich der zweiten Teilungsrichtung T.2 entgegengesetzt zueinander (also in die zweite Teilungsrichtung T.2 bzw. entgegen der zweiten Teilungsrichtung T.2 weisend) angeordnet; wenn dagegen das Pixel 13 entlang der zweiten Teilungsrichtung T.2 geteilt ist, sind die Transfergates 25 seiner zwei Detektorelemente 19 bezüglich der ersten Teilungsrichtung T.1 entgegengesetzt zueinander (also in die erste Teilungsrichtung T.1 bzw. entgegen der ersten Teilungsrichtung T.1 weisend) angeordnet.

Wie in Fig. 1 zu erkennen ist, hat diese Anordnung der Transfergates 25 zur Folge, dass zeilenweise und spaltenweise an jeden zweiten Zwischenraum 23 zwei Transfergates 25 angrenzen, während an die übrigen Zwischenräume 23 jeweils nur ein Transfergate 25 angrenzt. Die Zwischenräume 23, an die ein Transfergate 25 angrenzt, sind in Fig. 1 durch die Ziffer "1" gekennzeichnet, während die Zwischenräume 23, an die zwei Transfergates 25 angrenzen, in Fig. 1 durch die Ziffer "2" gekennzeichnet sind.

Jedes Transfergate 25 ist mit einem Sourcefolger-Transistor (nicht dargestellt) der Ausleseelektronik elektrisch verbunden, damit das jeweilige Detektorelement 19 darüber ausgelesen werden kann. Für jedes Transfergate 25, bei dem es sich um das einzige an einen jeweiligen Zwischenraum 23 angrenzende Transfergate 25 handelt, ist ein eigener Sourcefolger-Transistor vorgesehen. Dagegen sind zwei Transfergates 25, die an denselben Zwischenraum 23 angrenzen, mit einem einzelnen (also beide mit demselben) Sourcefolger-Transistor elektrisch verbunden, so dass die elektrischen Ladungen der beiden entsprechenden Detektorelemente 19 gemäß einer 2x-Shared-Pixel-Architektur über einen gemeinsamen Sourcefolger-Transistor ausgelesen werden. Dadurch kann die Ausleseelektronik besonders platzsparend ausgebildet sein.

Da bei dem Bildsensor 11 alle Pixel 13 des ersten Farbkanals G aufgrund ihrer Ausbildung mit zwei Detektorelementen 19 als PDAF-Pixel nutzbar sind, sind in der Pixelmatrix alle 2x2-Zellen (jeweils bestehend aus zwei diagonal entgegengesetzt zueinander angeordneten grünen Pixeln sowie einem roten Pixel und einem blauen Pixel) zueinander identisch. Anders als bei einem Bildsensor, der nur einzelne, verstreut angeordnete PDAF-Pixel aufweist, ist daher keine Interpolation erforderlich. Zudem können die beiden elektrischen Signale, die von den zwei Detektorelementen 19 eines jeweiligen dem ersten Farbkanal G zugeordneten Pixels 13 erzeugt werden, summiert werden, um für die Position des jeweiligen Pixels 13 die "normale" Bildinformation (Intensität des grünen Anteils des Lichts an dieser Stelle) zu erhalten. Auch aus diesem Grund brauchten die als PDAF-Pixel fungierenden Pixel 13 des ersten Farbkanals G nicht interpoliert zu werden.

Dadurch, dass nur die dem ersten Farbkanal G zugeordneten Pixel 13 zwei Detektorelemente 19 umfassen und somit als PDAF-Pixel geeignet sind, die dem zweiten Farbkanal R und die dem dritten Farbkanal B zugeordneten Pixel 13 dagegen nicht, erhöht sich bei dem Bildsensor 11 die Datenrate (Bandbreite der von den Pixeln 13 erzeugten Signale) lediglich um 50 % im Vergleich zu einer Erhöhung um mindestens 100 % bei Bildsensoren, bei denen sämtliche Pixel als PDAF-Pixel ausgebildet sind, indem sie mindestens zwei Detektorelemente 19 umfassen. Daher kann bei dem erfindungsgemäßen Bildsensor 11 auch die Verlustleistung vergleichsweise gering gehalten werden.

Wesentlich ist nicht nur, dass weniger Pixel 13 zwei Detektorelemente 19 umfassen als bei einem vollflächig mit PDAF-Pixeln ausgestatteten Bildsensor, sondern auch, dass es von dem jeweiligen Farbkanal G, R bzw. B abhängt, ob ein jeweiliges Pixel 13 zwei Detektorelemente 19 oder ein Detektorelement 19 umfasst. Es ist besonders vorteilhaft, wenn es sich bei den Pixeln 13, die zwei Detektorelemente 19 umfassen, um Pixel 13 handelt, die dem grünen Farbkanal G zugeordnet sind, da der grüne Farbkanal G der Luminanz entspricht und somit den Hauptteil der Bildinformation trägt. Zudem ist bei einem Bildsensor 11 mit Bayer-Maske die Dichte der dem grünen Farbkanal G zugeordneten Pixel 13 höher als die Dichte der dem roten Farbkanal R bzw. dem blauen Farbkanal B zugeordneten Pixel 13. Das hat zur Folge, dass der erfindungsgemäße Bildsensor 11 ähnlich gute Resultate beim Autofokus liefert wie ein vollflächig mit PDAF-Pixeln ausgestatteter Bildsensor bei deutlich reduzierter Datenrate.

### Bezugszeichen

- 11: Bildsensor
- 13: Pixel
- 15: Zeile
- 17: Spalte
- 19: Detektorelement
- 21: Detektionsfläche
- 23: Zwischenraum
- 25: Transfergate

## Patentansprüche

1. Bildsensor (11), insbesondere CMOS-Bildsensor, für eine elektronische Kamera, der eine Vielzahl von in Zeilen (15) und Spalten (17) angeordneten Pixeln (13) aufweist, von denen jedes einem von zumindest drei Farbkanälen (G, R, B) zugeordnet ist,
wobei jedes Pixel (13) zumindest ein lichtempfindliches Detektorelement (19), das dazu ausgebildet ist, in Abhängigkeit von auftreffendem Licht elektrische Signale zu erzeugen, sowie einen Farbfilter umfasst, welcher das Licht vor dem Auftreffen auf das zumindest eine Detektorelement (19) gemäß dem Farbkanal (G, R, B), dem das jeweilige Pixel (13) zugeordnet ist, filtert,
wobei jedes Pixel (13), das einem ersten Farbkanal (G) der drei Farbkanäle (G, R, B) zugeordnet ist, zumindest zwei lichtempfindliche Detektorelemente (19) umfasst, die dazu ausgebildet sind, unabhängig voneinander in Abhängigkeit von auftreffendem Licht elektrische Signale zu erzeugen, so dass eine Phasendifferenz zwischen den von den Detektorelementen (19) des jeweiligen Pixels (13) erzeugten elektrischen Signalen für einen Autofokus der Kamera nutzbar ist, wohingegen von den Pixeln (13), die nicht dem ersten Farbkanal (G) zugeordnet sind, zumindest einige, vorzugsweise die meisten, insbesondere alle, nur ein einzelnes lichtempfindliches Detektorelement (19) umfassen, das dazu ausgebildet ist, in Abhängigkeit von auftreffendem Licht elektrische Signale zu erzeugen,
**dadurch gekennzeichnet,**
**dass** jedes Pixel (13), das dem ersten Farbkanal (G) zugeordnet ist, genau zwei Detektorelemente (19) umfasst,
**dass** jedes Pixel (13), das dem ersten Farbkanal (G) zugeordnet ist, eine Gesamtfläche aufweist, die zeilenweise abwechselnd entlang einer zum Verlauf der Zeilen (15) und zum Verlauf der Spalten (17) diagonal ausgerichteten ersten Teilungsrichtung (T.1) oder einer zum Verlauf der Zeilen (15) und zum Verlauf der Spalten (17) diagonal ausgerichteten zweiten Teilungsrichtung (T.2), die quer, insbesondere orthogonal, zur ersten Teilungsrichtung (T.1) ausgerichtet ist, in zwei Hälften geteilt ist, wobei in der einen Hälfte das eine Detektorelement (19) des jeweiligen Pixels (13) angeordnet ist und in der anderen Hälfte das andere Detektorelement (19) des jeweiligen Pixels (13) angeordnet ist,
**dass** zwischen den Pixeln (13) Zwischenräume (23) vorgesehen sind, an die jeweils vier Pixel (13) angrenzen, wobei der Bildsensor (11) eine Ausleseelektronik umfasst, die sich in die Zwischenräume (23) erstreckt,
**dass** jedes Detektorelement (19) ein Transfergate (25) aufweist, an dem eine von dem Detektorelement (19) erzeugte elektrische Ladung an die Ausleseelektronik ausgebbar ist, wobei an jeden Zwischenraum (23) mindestens ein Transfergate (25) eines Detektorelements (19) eines an den Zwischenraum (23) angrenzenden Pixels (13) und höchstens ein weiteres Transfergate (25) eines Detektorelements (19) eines weiteren an den Zwischenraum (23) angrenzenden Pixels (13) angrenzen,
**dass** für jedes Pixel (13), das dem ersten Farbkanal (G) zugeordnet ist und dessen Gesamtfläche entlang der ersten Teilungsrichtung (T.1) geteilt ist, die Transfergates (25) seiner zwei Detektorelemente (19) bezüglich der zweiten Teilungsrichtung (T.2) entgegengesetzt zueinander angeordnet sind,
**dass** für jedes Pixel (13), das dem ersten Farbkanal (G) zugeordnet ist und dessen Gesamtfläche entlang der zweiten Teilungsrichtung (T.2) geteilt ist, die Transfergates (25) seiner zwei Detektorelemente (19) bezüglich der ersten Teilungsrichtung (T.1) entgegengesetzt zueinander sind, und
**dass** für jedes Pixel (13), das nicht dem ersten Farbkanal (G) zugeordnet ist, das Transfergate (25) seines Detektorelements (19) in die erste Teilungsrichtung (T.1) weisend angeordnet ist.

2. Bildsensor nach Anspruch 1,
wobei zumindest die Hälfte der Pixel (13) des Bildsensors (11) dem ersten Farbkanal (G) zugeordnet ist.

3. Bildsensor nach Anspruch 1 oder 2,
wobei sich in jeder Zeile (15) und jeder Spalte (17) des Bildsensors (11) Pixel (13), die dem ersten Farbkanal (G) zugeordnet sind, mit Pixeln (13), die nicht dem ersten Farbkanal (G) zugeordnet sind, abwechseln, wobei es sich bei dem ersten Farbkanal (G) vorzugsweise um einen grünen Farbkanal handelt.

4. Bildsensor nach Anspruch 3,
wobei die Pixel (13), die nicht dem ersten Farbkanal (G) zugeordnet sind, zeilenweise abwechselnd einem zweiten Farbkanal (R) oder einem dritten Farbkanal (B) zugeordnet sind,
wobei es sich bei dem zweiten Farbkanal (R) vorzugsweise um einen roten Farbkanal handelt und es sich bei dem dritten Farbkanal (B) vorzugsweise um einen blauen Farbkanal handelt.

5. Bildsensor nach einem der vorstehenden Ansprüche,
wobei jedes Detektorelement (19) eine Detektionsfläche (21) aufweist, auf die das Licht auftrifft, und
wobei für jedes Pixel (13), das dem ersten Farbkanal (G) zugeordnet ist, die Summe der Detektionsflächen (21) der zumindest zwei Detektorelemente (19) des jeweiligen Pixels (13) größer ist als die Detektionsfläche (21) des Detektorelements (19) eines Pixels (13), das nicht dem ersten Farbkanal (G) zugeordnet ist und nur ein einzelnes Detektorelement (19) umfasst.

6. Bildsensor nach Anspruch 5,
wobei die Pixel (13) des Bildsensors (11) an Positionen angeordnet sind, die ein regelmäßiges Raster von Zeilen (15) und Spalten (17) bilden, wobei die zumindest zwei lichtempfindlichen Detektorelemente (19) der Pixel (13) des ersten Farbkanals (G) gemeinsam an einer einzigen Position des Rasters angeordnet sind.

7. Bildsensor nach einem der vorstehenden Ansprüche,
wobei die Ausleseelektronik eine Vielzahl von Sourcefolger-Transistoren umfasst und jedes Transfergate (25) mit einem der Sourcefolger-Transistoren elektrisch verbunden ist, so dass über den Sourcefolger-Transistor die von dem jeweiligen Detektorelement (19) erzeugte elektrische Ladung auslesbar ist, und
wobei für zwei Transfergates (25), die an denselben Zwischenraum (23) angrenzen, jeweils beide Transfergates (25) mit demselben Sourcefolger-Transistor elektrisch verbunden sind, so dass die von den jeweiligen Detektorelementen (19) erzeugte elektrische Ladung über einen einzelnen gemeinsamen Sourcefolger-Transistor auslesbar ist.

## Claims

1. An image sensor (11), in particular a CMOS image sensor, for an electronic camera, said image sensor (11) comprising a plurality of pixels (13) which are arranged in rows (15) and columns (17) and each of which is associated with one of at least three color channels (G, R, B),
wherein each pixel (13) comprises at least one light-sensitive detector element (19), which is configured to generate electrical signals in dependence on incident light, and a color filter which filters the light prior to incidence on the at least one detector element (19) in accordance with the color channel (G, R, B) with which the respective pixel (13) is associated, wherein each pixel (13) which is associated with a first color channel (G) of the three color channels (G, R, B) comprises at least two light-sensitive detector elements (19) which are configured to generate electrical signals independently of one another in dependence on incident light so that a phase difference between the electrical signals generated by the detector elements (19) of the respective pixel (13) can be used for an autofocus of the camera, whereas, of the pixels (13) which are not associated with the first color channel (G), at least some, preferably most, in particular all, comprise only a single light-sensitive detector element (19) which is configured to generate electrical signals in dependence on incident light, **characterized in that**
each pixel (13) which is associated with the first color channel (G) comprises exactly two detector elements (19),
**in that** each pixel (13) which is associated with the first color channel (G) has a total surface which is alternately divided in a row-wise manner along a first division direction (T.1), which is oriented diagonally to the course of the rows (15) and to the course of the columns (17), or along a second division direction (T.2), which is oriented diagonally to the course of the rows (15) and to the course of the columns (17) and which is oriented transversely, in particular orthogonally, to the first division direction (T.1), into two halves, wherein the one detector element (19) of the respective pixel (13) is arranged in the one half and the other detector element (19) of the respective pixel (13) is arranged in the other half,
**in that** intermediate spaces (23) are provided between the pixels (13) and are adjoined by four pixels (13) in each case, wherein the image sensor (11) comprises readout electronics which extend into the intermediate spaces (23),
**in that** each detector element (19) has a transfer gate (25) at which an electric charge generated by the detector element (19) can be output to the readout electronics, wherein each intermediate space (23) is adjoined by at least one transfer gate (25) of a detector element (19) of a pixel (13) adjoining the intermediate space (23) and by at most one further transfer gate (25) of a detector element (19) of a further pixel (13) adjoining the intermediate space (23),
**in that**, for each pixel (13) which is associated with the first color channel (G) and whose total surface is divided along the first division direction (T.1), the transfer gates (25) of its two detector elements (19) are arranged opposite one another with respect to the second division direction (T.2), **in that**, for each pixel (13) which is associated with the first color channel (G) and whose total surface is divided along the second division direction (T.2), the transfer gates (25) of its two detector elements (19) are opposite one another with respect to the first division direction (T.1), and
**in that**, for each pixel (13) which is not associated with the first color channel (G), the transfer gate (25) of its detector element (19) is arranged facing in the first division direction (T.1).

2. An image sensor according to claim 1,
wherein at least half of the pixels (13) of the image sensor (11) are associated with the first color channel (G).

3. An image sensor according to claim 1 or 2,
wherein, in each row (15) and each column (17) of the image sensor (11), pixels (13) which are associated with the first color channel (G) alternate with pixels (13) which are not associated with the first color channel (G), wherein the first color channel (G) is preferably a green color channel.

4. An image sensor according to claim 3,
wherein the pixels (13) which are not associated with the first color channel (G) are alternately associated in a row-wise manner with a second color channel (R) or a third color channel (B),
wherein the second color channel (R) is preferably a red color channel and the third color channel (B) is preferably a blue color channel.

5. An image sensor according to any one of the preceding claims,
wherein each detector element (19) has a detection surface (21) on which the light is incident, and
wherein, for each pixel (13) which is associated with the first color channel (G), the sum of the detection surfaces (21) of the at least two detector elements (19) of the respective pixel (13) is greater than the detection surface (21) of the detector element (19) of a pixel (13) which is not associated with the first color channel (G) and which comprises only a single detector element (19).

6. An image sensor according to claim 5,
wherein the pixels (13) of the image sensor (11) are arranged at positions which form a regular grid of rows (15) and columns (17), wherein the at least two light-sensitive detector elements (19) of the pixels (13) of the first color channel (G) are jointly arranged at a single position of the grid.

7. An image sensor according to any one of the preceding claims,
wherein the readout electronics comprise a plurality of source follower transistors and each transfer gate (25) is electrically connected to one of the source follower transistors so that the electric charge generated by the respective detector element (19) can be read out via the source follower transistor, and
wherein, for two transfer gates (25) which adjoin the same intermediate space (23), both transfer gates (25) are in each case electrically connected to the same source follower transistor so that the electric charge generated by the respective detector elements (19) can be read out via a single common source follower transistor.

## Revendications

1. Capteur d'image (11), en particulier capteur d'image CMOS, pour une caméra électronique, qui présente une pluralité de pixels (13) disposés en lignes (15) et en colonnes (17), dont chacun est associé à l'un d'au moins trois canaux de couleur (G, R, B),
dans lequel chaque pixel (13) comprend au moins un élément détecteur photosensible (19) qui est conçu pour générer des signaux électriques en fonction de la lumière incidente ainsi qu'un filtre de couleur qui filtre la lumière avant qu'elle n'atteigne ledit au moins un élément détecteur (19) en fonction du canal de couleur (G, R, B) auquel le pixel (13) respectif est associé,
dans lequel chaque pixel (13) qui est associé à un premier canal de couleur (G) des trois canaux de couleur (G, R, B) comprend au moins deux éléments détecteurs photosensibles (19) qui sont conçus pour générer des signaux électriques indépendamment l'un de l'autre en fonction de la lumière incidente, de sorte qu'une différence de phase entre les signaux électriques générés par les éléments détecteurs (19) du pixel (13) respectif peut être utilisée pour un autofocus de la caméra, tandis que parmi les pixels (13) qui ne sont pas associés au premier canal de couleur (G), au moins certains, de préférence la plupart, en particulier tous, ne comprennent qu'un seul élément détecteur photosensible (19) qui est conçu pour générer des signaux électriques en fonction de la lumière incidente,
**caractérisé en ce**
**que** chaque pixel (13) qui est associé au premier canal de couleur (G) comprend exactement deux éléments détecteurs (19),
**que** chaque pixel (13) qui est associé au premier canal de couleur (G) présente une surface totale qui est divisée en deux moitiés, alternativement ligne par ligne, le long d'une première direction de division (T.1) orientée en diagonale par rapport au tracé des lignes (15) et au tracé des colonnes (17) ou d'une deuxième direction de division (T.2) orientée en diagonale par rapport au tracé des lignes (15) et au tracé des colonnes (17), qui est orientée transversalement, en particulier orthogonalement, à la première direction de division (T.1), un élément détecteur (19) du pixel (13) respectif étant disposé dans l'une des moitiés et l'autre élément détecteur (19) du pixel (13) respectif étant disposé dans l'autre moitié,
**que** des espaces intermédiaires (23) sont prévus entre les pixels (13) qui sont adjacents aux quatre pixels (13) respectifs, le capteur d'image (11) comprenant une électronique de lecture qui s'étend dans les espaces intermédiaires (23),
**que** chaque élément détecteur (19) présente une grille de transfert (25) à laquelle une charge électrique générée par l'élément détecteur (19) peut être transmise à l'électronique de lecture, au moins une grille de transfert (25) d'un élément détecteur (19) d'un pixel (13) adjacent à l'espace intermédiaire (23) et au maximum une autre grille de transfert (25) d'un élément détecteur (19) d'un autre pixel (13) adjacent à l'espace intermédiaire (23) étant adjacentes à chaque espace intermédiaire (23),
**que** pour chaque pixel (13) qui est associé au premier canal de couleur (G) et dont la surface totale est divisée le long de la première direction de division (T.1), les grilles de transfert (25) de ses deux éléments détecteurs (19) sont disposées de manière opposée l'une à l'autre par rapport à la deuxième direction de division (T.2),
**que** pour chaque pixel (13) qui est associé au premier canal de couleur (G) et dont la surface totale est divisée le long de la deuxième direction de division (T.2), les grilles de transfert (25) de ses deux éléments détecteurs (19) sont opposées l'une à l'autre par rapport à la première direction de division (T.1), et
**que** pour chaque pixel (13) qui n'est pas associé au premier canal de couleur (G), la grille de transfert (25) de son élément détecteur (19) est disposée dans la première direction de division (T.1).

2. Capteur d'image selon la revendication 1,
dans lequel au moins la moitié des pixels (13) du capteur d'image (11) sont associés au premier canal de couleur (G).

3. Capteur d'image selon la revendication 1 ou 2,
dans lequel, dans chaque ligne (15) et chaque colonne (17) du capteur d'image (11), les pixels (13) qui sont associés au premier canal de couleur (G) alternent avec des pixels (13) qui ne sont pas associés au premier canal de couleur (G),
dans lequel le premier canal de couleur (G) est de préférence un canal de couleur verte.

4. Capteur d'image selon la revendication 3,
dans lequel les pixels (13) qui ne sont pas associés au premier canal de couleur (G) sont associés alternativement ligne par ligne à un deuxième canal de couleur (R) ou à un troisième canal de couleur (B),
dans lequel le deuxième canal de couleur (R) est de préférence un canal de couleur rouge et le troisième canal de couleur (B) est de préférence un canal de couleur bleue.

5. Capteur d'image selon l'une des revendications précédentes,
dans lequel chaque élément détecteur (19) présente une surface de détection (21) sur laquelle la lumière tombe, et
dans lequel, pour chaque pixel (13) qui est associé au premier canal de couleur (G), la somme des surfaces de détection (21) desdits au moins deux éléments détecteurs (19) du pixel (13) respectif est supérieure à la surface de détection (21) de l'élément détecteur (19) d'un pixel (13) qui n'est pas associé au premier canal de couleur (G) et qui ne comprend qu'un seul élément détecteur (19).

6. Capteur d'image selon la revendication 5,
dans lequel les pixels (13) du capteur d'image (11) sont disposés à des positions qui forment une trame régulière de lignes (15) et de colonnes (17), lesdits au moins deux éléments détecteurs photosensibles (19) des pixels (13) du premier canal de couleur (G) étant disposés ensemble à une seule position de la trame.

7. Capteur d'image selon l'une des revendications précédentes,
dans lequel l'électronique de lecture comprend une pluralité de transistors suiveurs de source et chaque grille de transfert (25) est reliée électriquement à l'un des transistors suiveurs de source, de sorte que la charge électrique générée par l'élément détecteur (19) respectif peut être lue via le transistor suiveur de source, et
dans lequel, pour deux grilles de transfert (25) qui sont adjacentes au même espace intermédiaire (23), les deux grilles de transfert (25) sont reliées électriquement au même transistor suiveur de source, de sorte que la charge électrique générée par les éléments détecteurs (19) respectifs peut être lue via un seul transistor suiveur de source commun.
